# EUROPEAN PATENT APPLICATION

(11) **EP 0 637 847 A2**
(43) Date of publication of application: **08.02.1995**
(21) Application number: 94305830.5
(22) Date of filing: 05.08.1994
(51) Int. Cl.: H01L 29/73, H01L 29/861, H01L 27/07

(54) **Improvements in or relating to transistor switches**

(30) Priority: 06.08.1993 GB 9316368
(71) Applicant: TEXAS INSTRUMENTS INCORPORATED, Dallas Texas 75265 (US); TEXAS INSTRUMENTS LIMITED, Bedford MK41 7PA (GB)
(72) Inventor: Maytum,Mick, Willington Bedfordshire MK44 3QB (GB); Garnham,Dave, Sharnbrook Bedfordshire MK44 1HY (GB)
(74) Representative: Nettleton, John Victor

(57) **Abstract**

An electronic switch (80) having a transistor (T) and a diode (D) formed on a substrate (82) is provided. The electronic switch (80) includes a commong transistor collector and diode cathode region (81) of a first conductivity type formed in the substrate (82). The switch (80) also includes a transistor base region (83) of a second conductivity type formed in a first section of the collector region (81) and a transistor emitter region (84) of the first conductivity type formed in a section of the base region (80) includes a diode anode region (85) formed of the second conductivity type and in a second section of the collector region (81). At least a portion of the anode region (85) is selectively doped with a metallic dopant to provide centers for charge carrier recombination so as to increase the recovery time of the diode (D).

## Description

The present invention relates to transistor switches and in particular to the integration of a switching transistor with a reverse current diode as is necessary, for example, in applications where inductive loads are to be switched.

When a diode is formed integrated with a transistor it is convenient to form the diode in the semi-conductor material which forms the collector of the transistor straightforwardly to provide the required common connection therebetween. Unfortunately the characteristics of material chosen to provide a good switching transistor do not yield a diode performance that is acceptable in all applications. This problem is particularly severe when a high voltage, high power switch is considered. An example of an application in which the performance of a straightforwardly integrated transistor has proved unsatisfactory is in the inverter circuit of a fluorescent lamp.

Standard fluorescent lamps are extensively used in industrial and commercial environments. Compared to incandescent bulbs, fluorescent lamps have lower energy consumption and longer life, but in most domestic applications these advantages have been outweighed by the fluorescent's fitting size, the need for extra control gear, and the higher initial cost. As a result their use has been very selective. Also for applications like task lighting, a concentrated light source is needed rather than the distributed source given by the conventional fluorescent lamp.

For these reasons there is still an enormous market for incandescent (filament) bulbs. Recognising the need for a small efficient light source, the lamp manufacturers developed a range of compact fluorescent lamps. The small size is achieved by reducing the glass tube diameter and folding the tube one or more times. As with conventional florescent lamps these compact fluorescents still required a ballast and a starter. The starter problem was solved by building a glow starter into the tube base. Coupling such a compact fluorescent tube with ballast mounted in an adapter gave a light source which could replace incandescent bulbs.

Combining a compact fluorescent with a conventional 50/60 Hz ballast gave a light source that was restricted in its application area. In addition to higher additional cost with respect to a filament bulb the weight and bulk of the ballast made a resultant light source non-retrofitable in many incandescent bulb fittings. Physical size, for example, is a factor in determining the acceptability of these fittings and it is desirable that size be reduced as much as possible. This leads to a desire to integrate the electronic ballast components.

To address these problems, smaller lightweight electronic ballasts were developed to replace the 50/60 Hz ballasts. In some cases such compact lamps were not always compatible with the electronic ballast operation. Lamps would either flicker continuously or at random times during running. This problem was caused by the lamps glow starter being activated by the hf ac generated by the electronic ballast. So a new range of compacts was introduced where the glow starter was removed. This range of lamps is characterised by four connecting pins (two for each heater) compared to the previous two pin lamps which had an integral starter.

Operating the fluorescent tube at high frequency reduces the tube power required for a given light level. A 12 W 50 Hz rated tube might need only 10 W at high frequencies to produce the same light output. At the system level the total power drawn from the system supply might be 14 W for a 50 Hz ballast and only 11 W for a high frequency ballast. So generally a high frequency electronic ballast system draws less power than the comparable 50Hz operated tube. Key to this is that the high frequency ballast must have low losses. In particular the electronic switches, which generate the high frequency ac, need to be stable and low loss in addition to providing the necessary high voltage operation and reverse current performance. Current reversal as a result of a switching transient is normally dealt with by providing an anti-parallel diode. In a high voltage application where the reverse current is likely to be high, the diode will be physically large, as will the transistor itself. Hence in applications where circuit size reduction is desirable there is an extra incentive to integrate the diode to be added to such other advantages as reliability and reduced cost.

According to the present invention in one aspect thereof there is provided an electronic switch and method as defined in the claims.

In particular the invention provides an integral transistor and anti-parallel diode in semi-conductor material having characteristics suitable for switching.

In order that features and advantages of the present invention may be more fully appreciated embodiments will now be described by way of example only and with reference to the accompanying diagrammatic drawings of which:-
Fig 1 is a block diagram of an electronic ballast,
Fig 2 is a circuit diagram of a high frequency inverter,
Fig 3 shows inverter current and voltage waveforms,
Fig 4 shows switching current waveforms,
Fig 5 is a schematic of an integrated diode,
Fig 6 shows the reverse recovery characteristic of a straightforwardly integrated diode,
Fig 7 shows the reverse recovery characteristic of a diode integrated in accordance with the present invention, and
Figs 8 - 12 show fabrication steps.

A basic function of an electronic ballast is to convert ac at line frequency to a much higher one usually in the 30 - 40kHz region. It is overly complex to do a direct low frequency to high frequency conversion. Normally a two stage process used. The ac supply is first rectified to dc and this dc is chopped at high frequency to produce the ac to power the lamp.

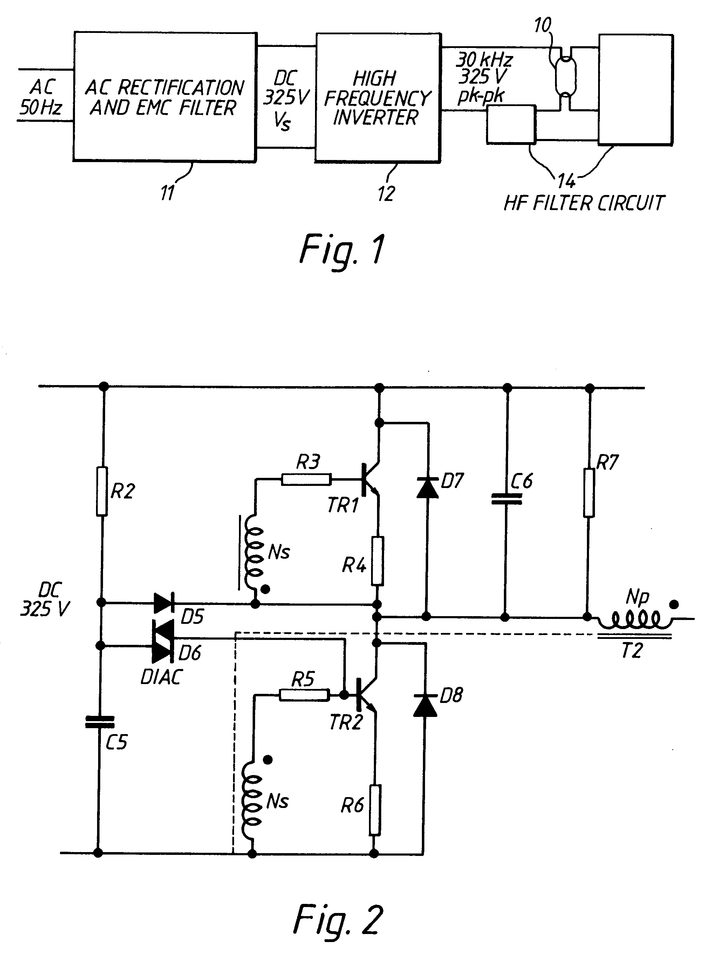

In an electronic ballast arrangement driving a fluorescent tube 10 (Fig. 1) an ac 50Hz supply is received at a rectifier and EMC filter 11. A dc supply voltage Vₛ, for example 325V, is provided to an hf inverter 12 which provides a 30KHz 325V supply to the tube 10. Associated with the tube 10 is an hf filter circuit 14.

Most European electronic ballast's are based on the principle of full wave rectifying the 50Hz ac supply to produce a dc supply voltage, Vs, in the range of 250 to 370V. (Where a boost converter is used to provide electronic power factor correction the dc rail voltage is higher, typically in the region of 400V). This dc supply then feeds an half "H" bridge inverter switching at 30 to 40 kHz. The high frequency waveform produced by the inverter then powers one or more fluorescent tubes via an LC filter network. This high frequency inverter section contains electronic switches which may be in accordance with the present invention.

The High Frequency Inverter will now be considered in more detail.

The function of the inverter is to chop the dc voltage produced by the ac rectification into high frequency ac. There are several forms the inverter can take. One is a push-pull configuration. Here, both switches have one connection made to a common supply rail, the other sides of the switches connecting to a (filter) transformer. Another common arrangement is the half "H" bridge. In this case two switches are series connected across a supply and the high frequency output is taken from the common connection, by way of example. Only the operation of the half "H" bridge will be described in detail. It will be appreciated however that the invention is not limited to an half "H" bridge nor even to inverters used in electronic lighting applications. It can be used in other power switching applications.

A half "H" bridge (fig 2) is formed by the transistor switches, TR1 and TR2, and their respective anti-parallel diodes, D7 and D8. The diodes are included to carry load current reversals in their respective transistor switches. Resistor R2, capacitor C5, and diac, D6, form a relaxation oscillator which "kick" transistor TR2 into conduction. Resistor pulls the collector voltage of transistor TR2 to the positive supply rail to ensure the correct start up bias. Once transistor TR2 conducts, self-oscillation is maintained by the positive feed-back from the driver transformer T2. In an alternative arrangement, the transistors may be driven from an external oscillator. This increases circuit complexity but allows the incorporation of additional features like dimming and remote control. So called "snubber" capacitor C6 slows down the waveform edges as the switches turn on and off. This reduces switch dissipation and waveform harmonics.

Emitter resistors R4 and R6, although representing a slight efficiency loss develop an emitter bias voltage which is dependent on load current. This gives an enhanced level of transistor reverse base current during turn off and helps to equalise any transistor turn off time difference. Also, during start up and fault conditions the high voltage level developed across these resistors helps to limit the peak currents in the transistors. In each transistor, series base resistors R3 and R5 respectively together with the transformer secondary winding voltage, respective transistor V_{be}'s and the voltage developed across the emitter resistor define the transistor base turn-off current I_{boff}.

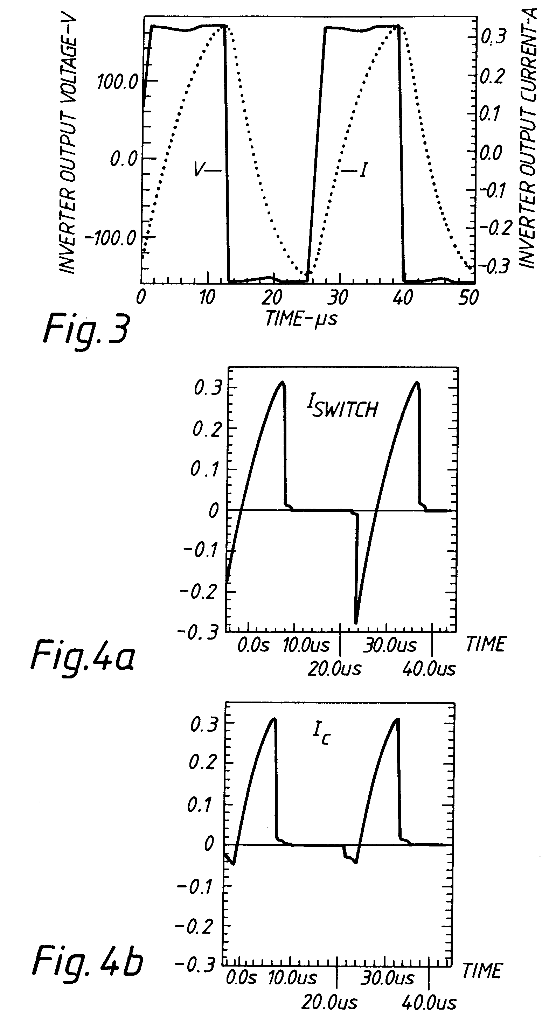

Fig. 3 shows the output voltage V, and current I of the inverter. It will be seen that the load (lamp) current changes polarity during the switch conduction time. This current reversal necessities the anti-parallel diodes, D7 and D8.

The actual switch current I_{switch}, the total of the diode and transistor currents, is shown in Figure 4a and Figure 4b shows that part of the switch current which flows through the transistor's collector (I_{c}).

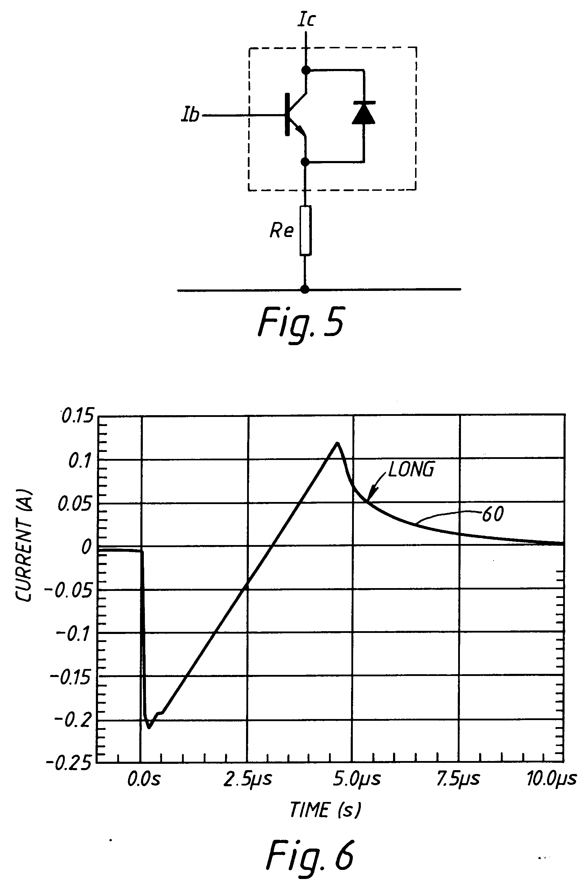

Integration of the diode and transistor is simplified if the diode cathode connection is moved to the transistor's emitter. With an integrated diode and transistor 50 (fig 5) the arrangement will be such that the emitter resistor R2 of the circuit of fig 2 would for example be connected as shown.

Straightforward integration of the transistor and diode has two major effects on operating frequency. First the transistor has the total switch current flowing through it and the increased charge level lengthens the transistors' storage time, which will lower the operating frequency of a self-oscillating inverter. This drop in operating frequency can normally corrected back to the original value by increasing the value of emitter resistor R2. Secondly the operating frequency drops due to the longer diode recovery time. Essentially the transistor has to wait for the diode to recover before it can start its normal conduction. So for efficient operation diode recovery time should be short. Unfortunately, the integrated diode is formed from the same material as the transistor's collector region. The requirements of this material for transistor operation means that is not optimized for fast recovery. The slow diode recovery makes the inverter circuit unstable on certain fluorescent lamps, and provides a circuit of inferior performance to that having a discrete diode, which may be separately optimized as a fast recovery device.

For example after switch-on fluorescent lamps take some time to achieve a stable running condition. The inverter sees this as a load current change with time. Unfortunately this change creates a positive feedback effect in the straightforwardly integrated diode transistor. If the negative (diode) current increases the diode will take longer to recover. This in turn causes the frequency of a self-oscillating inverter to decrease. The frequency decrease will cause the load current to increase which in turn will increase the diode current and decrease the frequency still further. The net result is that the change in operating conditions that this causes prevents the design of an inverter that produces a stable output as the lamp loading changes.

For adequate circuit performance what is required is an integrated diode with a comparable recovery time to an optimized discrete diode.

The present invention provides such an integrated fast recovery diode by virtue of selective doping of the semi-conductor material in which the diode is formed, the material being that optimized for the collector of the switching transistor. The doping provides centres for charge carrier recombination, suitable dopants being for example gold and platinum.

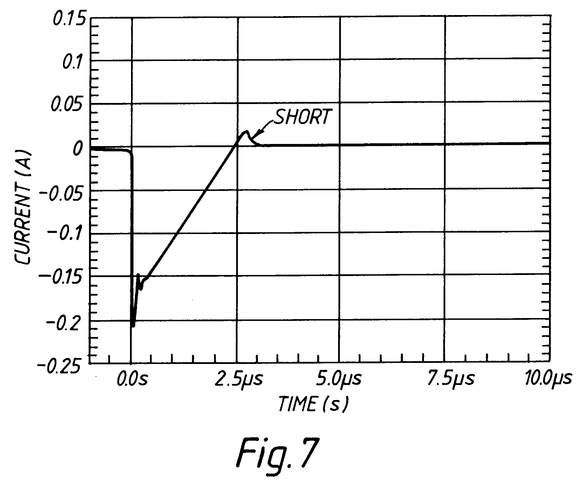

The recovery characteristic for a straightforwardly integrated diode is shown in fig 6, where a long recovery time portion 60 will be observed. The characteristic of the diode of the integrated device of the present invention is shown in fig 7 wherein a much shorter recovery time portion 70 will be observed. The structure of an exemplary device will now be considered.

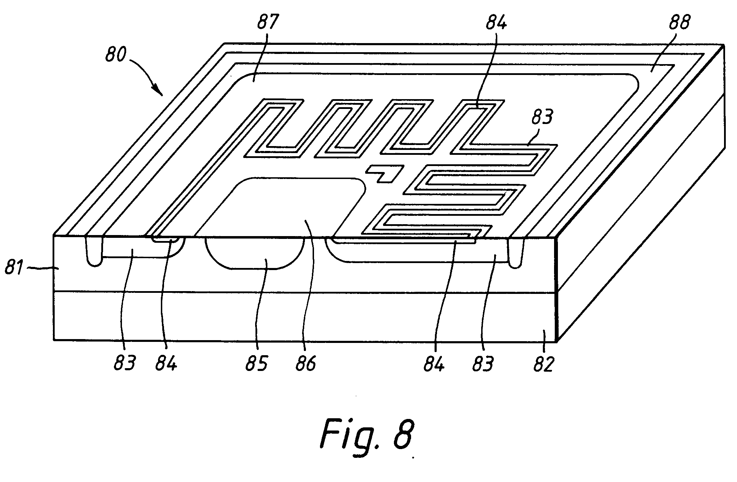

In a device 80 (fig 8) in accordance with the present invention an n-type collector region 81 is formed in substrate silicon 82 chosen for the switching application. A p-type base region 83 is formed in the surface of the collector region and an n-type emitter region 84 is formed therein. It will be observed that the size and shape of the regions is in accordance with the known high voltage/power switching transistor principles. In addition to the transistor thus far described, a p-type region 85 is formed to provide a junction diode in conjunction with the transistor collector region 81. A p-type implant 88 circumscribes the device to act as a field spreader. Commonly connected transistor collector and diode cathode may be contacted via the rear surface of the die. Metal layer regions 86 and 87 are placed to contact the emitter and bases respectively. Metal layer region 86 also overlies the diode region 85 to provide a common anode/emitter contact. Diode anode region 85 is selectively gold doped to provide a fast recovery diode leaving the performance of the switching transistor substantially unchanged.

The fabrication of the integrated transistor/diode device of fig 8 will now be described.

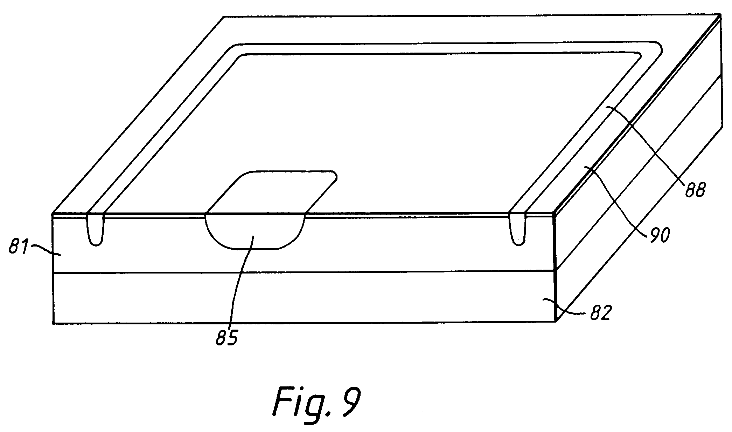

The starting material is 60-80 ohm.cm float-zone silicon onto which phosphorus is deposited at 1200 degrees c using POCl₃ as a dopant source for 4 hours then diffused at 1325 degrees C for 156 hours to achieve a penetration of 9.5 mils. A surface of the wafer is then ground and polished to give a substrate 82 (fig 9) having a n-type region 81 extending to the upper surface. This material will be recognised as suitable for the fabrication of a high voltage power switching transistor. The surface is then covered with an oxide layer 90 of 0.8µm or more which is then patterned and selectively removed to allow the region 88 to be formed by implantation. The implant is boron, 7.0 x 10¹² ions/cm² which is then diffused for 60 hours at 1300 degrees C giving a penetration of 4.4µm, oxide is again selectively removed to allow diode region 85 to be formed by implantation and diffusion (boron implant 5.2 x 10¹⁴ diffused for 2.2 hours at 1300 degrees C (penetration 0.64µm)).

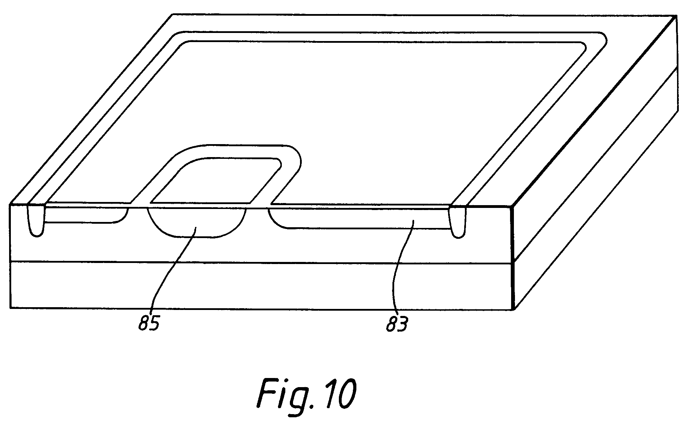

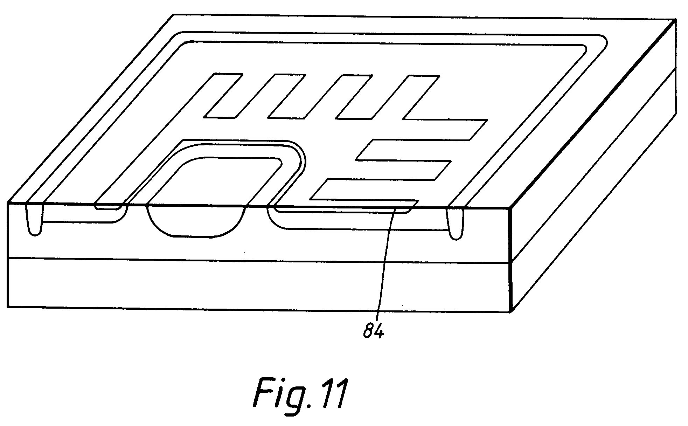

After further selective oxide removal another boron implant diffusion is made (5.2 x 10¹⁴ diffused for 2.2 hours at 1300 degrees C ) forming base region 83 (fig 10) and further driving in the diode anode region 85. A fresh oxide layer is applied and patterned for selective removal and phosphorus deposition. The phosphorous is diffused for 110 mins at 110 degrees C giving a penetration of 0.62µm to create emitter region 84 (fig 11). Next the oxide is patterned and selectively removed in preparation for the metal contact layer.

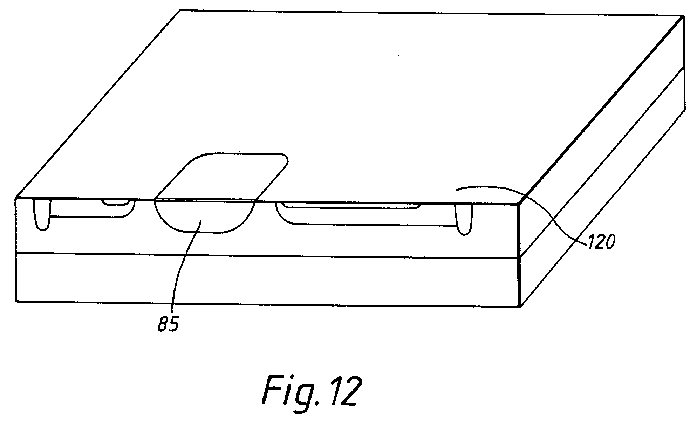

A layer of resist 120 is spun and patterned (fig 12). Gold (1 x 10¹³ ions/cm2) is implanted into the resist and patterned areas to produce a selectived doped diode region 85. The resit is then removed and the gold in the patterned areas is diffused for 15 mins at 900 degrees C. Finally a layer of aluminium is added to provide the electrical contacts to the upper surface after selective removal.

The resultant device (fig 8) is an integrated transistor and diode suited to switching applications. The gold doping applied selectively to the diode only gives improved recovery performance without affecting transistor performance. This will be contrasted with global gold doping techniques.

Devices of the type described have been successfully fabricated 105 mil square dies on 100mm diameter wafers.

## Claims

The matter for which the applicant seeks protection is:-

1. A diode formed in semiconductor material said diode having a region which is selectively doped with a dopant promoting charge carrier recombination.

2. A diode as claimed in claim 1 and wherein said dopant is gold.

3. A diode as claimed in claim 1 or claim 2 and wherein said region is coextensive with a diode active region.

4. An integrated device including a transistor and diode, said diode being a diode as claimed in any of claim 1, claim 2 or claim 3.

5. An integrated device as claimed in claim 4 wherein said semiconductor material is optimized for transistor operation.

6. An electronic ballast including an integrated device as claimed in claim 4 or claim 5.

7. An inverter including an integrated device as claimed in claim 4 or claim 5.

8. Lighting apparatus including an integrated device as claimed in claim 4 or claim 5.

9. A method for forming a device including a transistor and a diode formed on a substrate comprising the steps of:
forming a common transistor collector and diode cathod region of a first conductivity type in the substrate;
forming a transistor base region of a second conductivity type opposite the conductivity type to the first conductivity type in a first section of the collector region;
forming a transistor emitter region of the first conductivity in a section of the base region;
forming a diode anode region of the second conductivity type in a second section of the collector region, and
selectively doping at least a portion of the anode region with a metallic dopant to provide centers for charge carrier recombination so as to increase the recovery time of the diode.

10. The method of claim 9, wherein the step of selectively doping comprises selectively doping the anode with gold.

11. The method of claim 9, wherein the step of selectively doping comprises selectively doping the anode with platinum.

12. The method of any of claims 9 to 11, wherein the selectively doping step further comprises doping the entire anode region.

13. The method of any of claims 9 to 12, further comprising providing the first conductivity type as an n-type material.
